(19) Europäisches Patentamt
European Patent Office
Office européen des brevets

(11) **EP 2 885 825 B1**

(12) **EUROPÄISCHE PATENTSCHRIFT**

(45) Veröffentlichungstag und Bekanntmachung des Hinweises auf die Patenterteilung:
**06.07.2016 Patentblatt 2016/27**

(21) Anmeldenummer: **13765322.6**

(22) Anmeldetag: **11.09.2013**

(51) Int Cl.:
***H01L 51/54*** *(2006.01)*

(86) Internationale Anmeldenummer:
**PCT/EP2013/068826**

(87) Internationale Veröffentlichungsnummer:
**WO 2014/048753 (03.04.2014 Gazette 2014/14)**

(54) **PHOSPHOROXO-SALZE ALS N-DOTIERSTOFFE FÜR DIE ORGANISCHE ELEKTRONIK**

SALTS OF PHOSPHORUS OXIDE AS N-DOPANTS FOR ORGANIC ELECTRONICS

SELS PHOSPOROXO EN TANT QUE SUBSTANCES DOPANTES N POUR L'ÉLECTRONIQUE ORGANIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.09.2012 DE 102012217574**

(43) Veröffentlichungstag der Anmeldung:
**24.06.2015 Patentblatt 2015/26**

(73) Patentinhaber: **Siemens Aktiengesellschaft 80333 München (DE)**

(72) Erfinder:
• **SCHMID, Günter**
**91334 Hemhofen (DE)**
• **KANITZ, Andreas**
**91315 Höchstadt (DE)**
• **WEMKEN, Jan Hauke**
**90449 Nürnberg (DE)**

(56) Entgegenhaltungen:
**WO-A2-2011/039323      JP-A- 2004 335 137**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft ein organisch elektronisches Bauelement enthaltend ein Substrat, eine erste Elektrode, eine zweite Elektrode und mindestens eine, zwischen der ersten und zweiten Elektrode angeordnete, elektronenleitende Schicht, dadurch gekennzeichnet, dass die elektronenleitende Schicht ein salzartiges Derivat einer Phosphoroxo-Verbindung als n-Dotand enthält. Diese Schichtfolge kann in ein komplexes Bauelement, zum Beispiel eine OLED, eingebettet sein.

Stand der Technik

Die Tatsache, dass die Elektronenleitfähigkeit organischer Schichten durch eine allgemeine Dotierung mit Fremdsubstanzen gesteigert werden kann ist hinlänglich bekannt. Zeigen die Verbindungen, welche als Dotanden eingesetzt werden sollen, eine geeignete HOMO/LUMO (Highest Occupied Molecular Orbital/Lowest Unoccupied Molecular Orbital)-Relation zur organischen Matrix, so kann ein Elektron vom Dotanden zur Matrix übertragen werden und als Konsequenz dessen steigt die Ladungsträgerdichte und damit in der Regel die Leitfähigkeit der organischen, elektrisch leitenden Schicht. Dieser Mechanismus bildet generell eine der Grundlagen des Aufbaus und zur Optimierung organisch elektrischer Bauelemente.

In Abhängigkeit ihrer Funktionalität lassen sich die oben genannten organischen Bauelemente in Gruppen unterteilen, welche in der Lage sind

- Licht in elektrischen Strom umzuwandeln, zum Beispiel organische Solarzellen deren Aufbau schematisch in Figur I dargestellt ist,
- Licht aus elektrischen Strom zu erzeugen, zum Beispiel organische Leuchtdioden deren Aufbau schematisch in Figur II dargestellt ist, und
- elektrischen Strom zu steuern, zum Beispiel organische Feldeffekt-Transistoren deren Aufbau schematisch in Figur III dargestellt ist.

Allen Bauteilklassen ist gemein, dass die Güte der Bauteile sich im Wesentlichen durch die Ladungsträgerdichte und - beweglichkeit der zum Einsatz kommenden organischen Schichten ergibt.

Zur Erhöhung der Elektronenleitfähigkeit werden in der organischen Elektronik grundsätzlich zwei unterschiedliche Verfahren eingesetzt. Zum einen kann eine Erhöhung der Ladungsträgerbeweglichkeit durch das Einfügen einer Zwischenschicht zwischen Kathode und Elektronentransportschicht erreicht werden. Zum anderen liefert das n-Dotieren elektrisch leitfähiger, organischer Matrixmaterialien mit Donoren unterschiedlicher Stärke die zweite Möglichkeit.

Für erstgenannte Methode werden oft dünne Salzschichten, welche die Austrittsarbeit der Elektronen erniedrigen, aus LiF, CsF oder, in der neueren Literatur, Caesiumcarbonat eingesetzt. Die Eigenschaften und Auswirkungen von Caesiumcarbonat werden dabei z.B. durch Huang, Jinsong et al., Adv. Funct. Mater. 2007, 00, 1-8.; Wu, Chih-I et al., APPLIED PHYSICS LETTERS 88, 152104 (2006) und Xiong, Tao et al., APPLIED PHYSICS LETTERS 92, 263305 (2008) beschrieben. Durch diese Zwischenschichten wird der Elektronentransport signifikant verbessert, für hocheffiziente Bauteile ist diese Verbesserung jedoch unzureichend.

Zur Dotierung elektronischer Transportschichten werden hingegen allgemein Substanzen verwendet, deren HOMO (Highest Occupied Molecular Orbital) oberhalb des LUMOs (Lowest Unoccupied Molecular Orbital) des Matrixmaterials liegt. Dies ist eine Voraussetzung, um eine Elektron vom Dotanden auf das Matrixmaterial zu übertragen und so dessen Leitfähigkeit zu erhöhen. Zusätzlich werden des Weiteren bevorzugt Substanzen eingebracht, deren Valenzelektronen sehr niedrige Austrittsarbeiten beziehungsweise Ionisierungsenergien aufweisen. Auch dieses kann die Elektronenabgabe des Dotanden erleichtern und die Schichtleitfähigkeit erhöhen.

In der Literatur werden erfolgreiche Dotanden genannt, welche Alkali- und Erdalkalimetalle oder Lanthanoiden als Kationen enthalten. So wird zum Beispiel die Verwendung von Dikalium-Phthalat durch Meng-Huan Ho et al. beschrieben (Applied Physics Letters 93, 083505, 2008). Andere Ansätze, wie zum Beispiel von Schmid et al. (Organic Electronic Conference; Sept. 24.-26. 2007 Frankfurt Germany) und Meng-Huan Hoa et al. (Applied Physics Letters 91, 233507; 2007) verfolgt, beschäftigen sich mit dem Einsatz von Caesiumcarbonat zur Dotierung von Elektronenleitern in OLEDs. Letztere fanden, dass die durch eine Caesiumsalz-Dotierung erreichbaren Leitfähigkeitsverbesserungen der Matrixschicht im Wesentlichen eine Funktion des Anions des verdampften Salzes sind. Zusätzlich wurde gezeigt, dass das Anion einen geringeren Einfluss auf die Verdampfbarkeit der Verbindung als solches ausübt. Diese Verdampfungstemperatur bildet natürlich einen wesentlichen Parameter in der Prozessierbarkeit der Verbindung und aus energetischen Gesichtspunkten ist eine hohe Verdampfungstemperatur in der Prozessführung unvorteilhaft.

Eine hohe Verdampfungstemperatur ist auch nachteilig in der Verwendung von Caesiumphosphat als Dotand, wie sie zum Beispiel in der WO 2011 039323 A2 offenbart wird. Zwar lassen sich durch die Dotierung mit diesem Salz sehr gute n-Leitfähigkeiten organischer Schichten erhalten, aber aufgrund des salzartigen Charakters des Dotanden muss man mit hohen Sublimationstemperaturen arbeiten, welches prozesstechnisch den Dotierungsschritt erschwert.

Es ist daher die Aufgabe der vorliegenden Erfindung ein organisch elektronisches Bauelement zur Verfügung zu stellen, welches gegenüber dem Stand der Technik verbesserte Eigenschaften aufweist und sich einfach und kostengünstig herstellen lässt. Desweiteren wird ein Weg zu dessen Herstellung offenbart.

Gelöst wird diese Aufgabe durch die Merkmale des unabhängigen Anspruchs 1. Besondere Ausführungsformen der Erfindung werden in den Unteransprüchen wiedergegeben.

Detaillierte Beschreibung der Erfindung

Erfindungsgemäß ist demzufolge ein organisch elektronisches Bauelement enthaltend ein Substrat, eine erste Elektrode, eine zweite Elektrode und mindestens eine, zwischen der ersten und zweiten Elektrode angeordnete, elektronenleitende Schicht, dadurch gekennzeichnet, dass die elektronenleitende Schicht ein salzartiges Derivat einer Phosphoroxo-Verbindung gemäß allgemeiner Formel 1 als n-Dotand enthält

$$X \left[ \begin{array}{c} O \\ \parallel \\ R_2-P-O \\ \mid \\ R_1 \end{array} \right]^{n-} Y\ M^{m+} \qquad \text{(Formel 1),}$$

wobei X, Y größer 0 und kleiner oder gleich 3; n, m ganzzahlig und n größer oder gleich 1 und kleiner oder gleich 2 und m größer oder gleich 1 und kleiner oder gleich 3; M = Metall und $R_1$ = O, S, Se, O-R, S-R, Se-R und $R_2$ = R, O-R, S-R, Se-R und R aus der Gruppe enthaltend substituierte oder unsubstituierte Alkyl, langkettiges Alkyl, Cycloalkyl, Halogenalkyl, Aryl, Arylene, Halogenaryl, Heteroaryl, Heteroarylene, Heterocycloalkylene, Heterocycloalkyl, Halogenheteroaryl, Alkenyl, Halogenalkenyl, Alkinyl, Halogenalkinyl, Ketoaryl, Halogenketoaryl, Ketoheteroaryl, Ketoalkyl, Halogen-Ketoalkyl, Ketoalkenyl, Halogenketoalkenyl ausgewählt ist.

Überraschenderweise hat sich herausgestellt, dass organisch elektronische Bauelemente mit elektronenleitenden Schichten, welche als Bestandteile salzartige Derivate einer Phosphoroxo-Verbindung gemäß Formel 1 als n-Dotanden enthalten verbesserte elektronische Eigenschaften aufweisen und sich einfacher und kostengünstiger verdampfen lassen. Insbesondere der Einsatz salzartiger Derivate von Phosphoroxo-Verbindungen als n-Dotanden führt dazu, dass die elektrische Leitfähigkeit der elektronenleitenden Schicht signifikant erhöht wird. Des Weiteren wird durch die Verwendung der erfindungsgemäßen salzartigen Phosphoroxo-Derivate gegenüber den aus dem Stand der Technik bekannten Dotanden eine Absenkung der Sublimationstemperatur dieser Verbindungen erreicht, welches sich positiv auf den Gesamtenergiebedarf der Herstellung und die Gleichmäßigkeit der erhaltenen Schichten auswirkt.

Ohne durch die Theorie gebunden zu sein ergibt sich die Absenkung der Sublimationstemperatur des Dotanden durch die Derivatisierung der salzartigen Phosphoroxo-Verbindungen. Die Derivatisierung erhöht zwar die molekulare Masse der Phosphoroxo-Verbindung und würde so zu einer prinzipiellen Steigerung der Verdampfungstemperatur beitragen. Da es sich jedoch um die Verdampfung einer salzartigen Verbindung handelt, werden hochwahrscheinlich durch den sterischen Effekt der organischen Substituenten die ionischen Wechselwirkungen zwischen den Anionen und Kationen derart abgeschwächt, so dass sich im Vergleich zu den nicht derivatisierten Verbindungen insgesamt eine Reduzierung der ionischen Wechselwirkungen zwischen Anion und Kation ergibt. Die Trennungsenergie der Anionen und Kationen wird also herabgesetzt. Als Konsequenz dessen kann sich die derivatisierte Verbindung trotz höherem Molekulargewicht leichter verdampfen lassen.

Die erfindungsgemäße Derivatisierung des Dotanden lässt sich formal durch die Substitution eines oder zweier Sauerstoffatome eines Phosphorsäure-Salzes beschreiben. Die entstehende Phosphoroxo-Verbindung bildet das Anion der salzartigen Verbindung und kann eine einfach oder zweifach negative Ladung n tragen.

Der Stöchiometriekoeffizienten X, Y des Anions und des Kations müssen nicht ganzzahlig sein und können größer 0 und kleiner oder gleich 3 betragen. Nicht ganzzahlige Stöchiometriekoeffizienten des Anions oder des Kations besagen, dass ein Anion oder ein Kation mit mehreren anderen Gegenionen koordiniert ist. Allgemein gilt, dass das Produkt aus Stöchiometriekoeffizient und Ladung des Anions gleich dem Produkt aus Stöchiometriekoeffizient und Ladung des Kations ist. Die Ladungskoeffizienten n und m des Anions und des Kations können nur ganzzahlige, positive Werte annehmen. Die Ladung des Anions ergibt sich dann als der negative Wert des Ladungskoeffizienten n und die Ladung des Kations als positiver Wert des Ladungskoeffizienten m.

Das Anion enthält die beiden Substituenten $R_1$ und $R_2$, wobei $R_1$ ausgewählt ist aus der Gruppe O, S, Se, O-R, S-R, Se-R. Der Substituent R hingegen ist ausgewählt aus der Gruppe enthaltend substituierte oder unsubstituierte Alkyl, langkettiges Alkyl, Cycloalkyl, Halogenalkyl, Aryl, Arylene, Halogenaryl, Heteroaryl, Heteroarylene, Heterocycloalkylene, Heterocycloalkyl, Halogenheteroaryl, Alkenyl, Halogenalkenyl, Alkinyl, Halogenalkinyl, Ketoaryl, Halogenketoaryl, Ketoheteroaryl, Ketoalkyl, Halogen-Ketoalkyl, Ketoalkenyl, Halogenketoalkenyl. $R_1$ kann nach dieser Definition sowohl nur ein an den Phosphor gebundenes Sauerstoff-, Schwefel- oder Selenatom repräsentieren oder aber auch komplexere organische Verbindungen in denen das Sauerstoff-, Schwefel- oder Selenatom zusätzlich noch einen der oben angegebenen organischen Reste trägt.

Der Substituent $R_2$ hingegen ergibt sich erfindungsgemäß zu R, O-R, S-R, Se-R, wobei R ausgewählt ist aus der Gruppe enthaltend substituierte oder unsubstituierte Alkyl, langkettiges Alkyl, Cycloalkyl, Halogenalkyl, Aryl, Arylene, Halogenaryl, Heteroaryl, Heteroarylene, Heterocycloalkylene, Heterocycloalkyl, Halogenheteroaryl, Alkenyl, Halogenalkenyl, Alkinyl, Halogenalkinyl, Ketoaryl, Halogenketoaryl, Ketoheteroaryl, Ketoalkyl, Halogen-Ketoalkyl, Ketoalkenyl, Halogenketoalkenyl. $R_2$ kann demzufolge einen organischen Rest R darstellen, welcher direkt an den Phosphor gebunden ist oder einen organischen Rest R welcher über ein Sauerstoff-, Schwefel- oder Selenatom mit dem Phosphor verbunden ist.

Beide Substituenten $R_1$ und $R_2$ können unabhängig voneinander gewählt werden und eine Verbindung in welcher $R_1$ = $R_2$ = Sauerstoff ist, ist nicht erfindungsgemäß.

Innerhalb der Beschreibung und den Ansprüchen werden allgemeine Gruppen, wie z.B: Alkyl, Alkoxy, Aryl etc. beansprucht und beschrieben. Wenn nicht anders beschrieben, werden bevorzugt die folgenden Gruppen innerhalb der allgemein beschriebenen Gruppen im Rahmen der vorliegenden Erfindung verwendet:

alkyl: lineare und verzweigte C1-C8-Alkyle,

langkettige Alkyle: lineare und verzweigte C5-C20 Alkyle

Alkenyl: C2-C6-alkenyl,

Cycloalkyl: C3-C8-cycloalkyl,

Alkylene: ausgewählt aus der Gruppe enthaltend: methylene; 1,1-ethylene; 1,2-ethylene; 1,1-propylidene; 1,2-propylene; 1,3- propylene; 2,2-propylidene; butan-2-ol-1,4-diyl; propan-2-ol-1,3-diyl; 1, 4-butylene; cyclohe-xane-1,1-diyl; cyclohexan-1,2-diyl; cyclohexan-1,3- diyl; cyclohexan-1,4-diyl; cyclopentane-1,1-diyl; cyclopentan-1,2-diyl; und cyclopentan-1,3-diyl,

Aryl: ausgewählt aus Aromaten mit einem Molekulargewicht unter 300Da.

Arylene: ausgewählt aus der Gruppe enthaltend: 1,2-phenylene; 1,3- phenylene; 1,4-phenylene; 1,2-naphthylene; 1,3-naphtalenylene; 1,4- naphthylene; 2,3-naphthylene; 1-hydroxy-2,3-phenylene; 1-hydroxy-2,4- phenylene; 1-hydroxy-2,5- phenylene; und 1-hydroxy-2,6-phenylene,

Heteroaryl: ausgewählt aus der Gruppe enthaltend: pyridi-nyl; pyrimidinyl; pyrazinyl; triazolyl; pyridazinyl; 1,3,5-triazinyl; chinoninyl; isochinoninyl; chinoxalinyl; imidazolyl; pyrazolyl; benzimidazolyl; thiazolyl; oxazolidinyl; pyrrolyl; thiophenyl; carbazolyl; indolyl; und isoindolyl, wobei das Heteroaryl mit der Verbindung über jedes Atom im Ring des ausgewählten Heteroaryls verbunden sein kann.

Heteroarylene: ausgewählt aus der Gruppe enthaltend: pyridindiyl; quinolindiyl; pyrazodiyl; pyrazoldiyl; triazolediyl; pyrazindiyl, thiophendiyl; und imidazolediyl, wobei das Heteroarylene als Brücke in der Verbindung über ein beliebiges Atom im Ring des ausgewählten Heteroaryls fungiert, speziell bevorzugt sind: pyridin-2, 3-diyl; pyridin-2,4-diyl; pyridin-2,5-diyl; pyridin-2,6-diyl; pyridin-3,4- diyl; pyridin-3,5-diyl; quinolin-2,3-diyl; quinolin-2,4-diyl; quinolin-2,8-diyl; isoquinolin-1,3-diyl; isoquinolin-1,4-diyl; pyrazol-1,3-diyl; pyrazol-3,5- diyl; triazole-3,5-diyl; triazole-1,3-diyl; pyrazin-2,5-diyl; und imidazole-2,4-diyl, thiophen-2,5-diyl, thiophen-3,5-diyl; ein -C1-C6-heterocycloalkyl, ausgewählt aus der Gruppe enthaltend: piperidinyl; piperidine; 1,4-piperazine, tetrahydrothiophene; tetrahydrofuran; 1,4,7-triazacyclononane; 1,4,8,11- tetraazacyclotetradecane; 1,4,7,10,13-pentaazacyclopentadecane; 1,4-diaza- 7-thiacyclononane; 1,4- diaza-7-oxa-cyclononane; 1,4,7,10-tetraazacyclododecane; 1,4-dioxane; 1,4, 7-trithia-cyclononane; pyrrolidine; und tetrahydropyran, wobei das Heteroaryl mit dem C1-C6-Alkyl über jedes Atom im Ring des ausgewählten Heteroaryls verbunden sein kann.

Heterocycloalkylene: ausgewählt aus der Gruppe enthaltend: piperidin-1,2- ylene; piperidin-2,6-ylene; piperidin-4,4-ylidene; 1,4-piperazin-1,4-ylene; 1,4-piperazin-2,3-ylene; 1,4-piperazin-2,5-ylene; 1,4-piperazin-2,6-ylene; 1,4-piperazin- 1,2-ylene; 1,4-piperazin-1,3-ylene; 1,4-piperazin-1,4-ylene; tetrahydrothiophen-2,5-ylene; tetra-hydrothiophen-3,4-ylene; tetrahydrothiophen-2,3-ylene; tetrahydrofuran-2,5-ylene; tetrahydrofuran- 3,4-ylene; tetrahydrofuran-2,3-ylene; pyrrolidin-2,5-ylene; pyrroli-din-3,4-ylene; pyrrolidin-2,3-ylene; pyrrolidin-1,2-ylene; pyrrolidin-1,3-ylene; pyrrolidin-2,2-ylidene; 1,4,7-triazacyclonon-1,4-ylene; 1,4,7- tria-zacyclonon-2,3-ylene; 1,4,7-triazacyclonon-2,9-ylene; 1,4,7-triazacyclonon-3,8-ylene; 1,4,7-triazacyclonon-2,2- ylidene; 1,4,8,11-tetraazacyclotetradec-1,4-ylene; 1,4,8,11- tetraaza-cyclo-tetradec-1,8-ylene; 1,4,8,11-tetraazacyclotetradec-2,3-ylene; 1,4,8,11-tetraazacyclotetradec-2,5-ylene; 1,4,8,11-tetraazacyclotetradec-1,2-ylene; 1,4,8,11- tetraazacyclo-tetradec-2,2-ylidene; 1,4,7,10-tetraazacyclododec-1,4-ylene; 1,4,7,10-tetraazacyclododec-1,7-ylene; 1,4,7,10-tetraazacyclododec-1,2-ylene; 1,4,7,10-tetraazacyclododec-2,3- ylene; 1,4,7,10-tetraazacyclododec-2,2-ylidene; 1,4,7,10,13 pentaazacyclopentadec-1,4-ylene; 1,4,7,10,13-pentaazacyclopentadec-1,7-ylene; 1,4,7,10,13-pentaazacyclopentadec-2,3- ylene; 1,4,7,10,13-pentaazacyclopentadec-1,2-ylene; 1,4,7,10, 13-pentaazacyclopentadec-2,2-ylidene; 1,4-diaza-7-thia-cyclonon-1,4-ylene; 1,4-diaza-7-thia-cyclonon-1,2-ylene; 1,4-diaza-7thia-cyclonon- 2,3-ylene; 1,4-diaza-7-thia-cyclonon-6,8-ylene; 1,4-diaza-7-thia-cyclonon- 2,2-ylidene; 1,4-diaza-7-oxacyclonon-1,4-ylene; 1,4-diaza-7-oxa-cyclonon- 1,2-ylene; 1,4diaza-7-oxa-cyclonon-2,3-ylene; 1,4-diaza-7-oxa-cyclonon-6, 8-ylene; 1,4-diaza-7-oxa-cyclonon-2,2-ylidene; 1,4-dioxan-2,3-ylene; 1,4- dioxan-2,6-ylene; 1,4-dioxan-2,2-ylidene; tetrahydropyran-2,3-ylene; tetrahydropyran-2,6-ylene; tetra-hydropyran-2,5-ylene; tetrahydropyran-2,2- ylidene; 1,4,7-trithia-cyclonon-2,3-ylene; 1,4,7-trithia-cyclonon-2,9- ylene; und 1,4,7-trithia-cyclonon-2,2-ylidene,

Heterocycloalkyl: ausgewählt aus der Gruppe enthaltend: pyrrolinyl; pyrrolidinyl; morpholinyl; piperidinyl; piperazinyl; hexamethylene imine; 1,4-piperazinyl; tetrahydrothiophenyl; tetrahydrofuranyl; 1,4,7- triazacyclononanyl; 1,4,8,11-tetraazacyclotetradecanyl; 1,4,7,10,13- pentaazacyclopentadecanyl; 1,4-diaza-7-thiacyclononanyl; 1,4-diaza-7-oxa- cyclo-nonanyl; 1,4,7,10-tetraazacyclododecanyl; 1,4-dioxanyl; 1,4,7- trithiacyclononanyl; tetrahydropyranyl; und oxazolidinyl, wobei das Heterocycloalkyl mit der Verbindung über jedes Atom im Ring des ausgewählten Heterocycloalkyls verbunden sein kann.

Der Substituent R kann zudem an jeder bindungsfähigen Stelle seines Grundkörpers substituierte oder unsubstituierte Heterozyklen aufweisen. Vorzugsweise können die Substituenten aus substituierten und unsubstituierter Heterocyclen wie z.B. Furan, Thiophen, Pyrrol, Oxazol, Thiazol, Imidazol, Isoxazol, Isothazol, Pyrazol, Pyridin, Pyrazin, Pyrimidin, 1,3,6 Triazin, Pyrylium, alpha-Pyrone, gamma-Pyrone, Benzofuran, Benzothiophen, Indol 2H-Isoindol, Benzothiazol,2-benzothiophene, 1H-benzimidazole, 1H-benzotriazole, 1,3 benzoxazole, 2-benzofuran, 7H-purine, Chinolin, Iso-Chinolin, Quinazoline, Quinoxaline, phthalazine, 1,2,4-benzotriazine, Pyrido[2,3-d]pyrimidine, Pyrido[3,2-d]pyrimidine, pteridine, acridine, phenazine, benzo[g]pteridine, 9H-carbazole und Bipyridin und deren Derivaten ausgewählt werden. Eine weitere Substitution von R mit raumgreifenden Substituenten kann zu einer weiteren Erniedrigung der Sublimationstemperatur der salzartigen Verbindung führen. Zudem können sich durch zusätzliche Substituenten die HOMO/LUMO-Lagen beeinflussen.

Die erfindungsgemäßen Elektronen leitenden Schichten können Elektronentransportmaterialien, Elektronenakzeptoren und organische Elektronendonor-Verbindungen enthalten.

Elektronentransportmaterialien zur Aufnahme und Weitertransport von Elektronen sind im Stand der Technik bekannt und bevorzugte Materialien können ausgewählt werden aus der Gruppe umfassend 2,2',2" -(1,3,5-Benzinetriyl)-tris(1-phenyl-1-H-benzimidazole), 2-(4-Biphenylyl)-5-(4-tert-butylphenyl)-1,3,4-oxadiazole; 2,9-Dimethyl-4,7-diphenyl-1,10-phenanthroline (BCP), 8-Hydroxyquinolinolato-lithium; 4-(Naphthalen-1-yl)-3,5-diphenyl-4H-1,2,4-triazole; 1,3-Bis[2-(2,2'-bipyridine-6-yl)-1,3,4-oxadiazo-5-yl]benzene; 4,7-Diphenyl-1,10-phenanthroline (BPhen); 3-(4-Biphenylyl)-4-phenyl-5-tert-butylphenyl-1,2,4-triazole ;Bis(2-methyl-8-quinolinolate)-4-(phenylphenolato)aluminium; 6,6'-Bis[5-(biphenyl-4-yl)-1,3,4-oxadiazo-2-yl]-2,2'-bipyridyl ;2-phenyl-9,10-di(naphthalen-2-yl)-anthracene; 2,7-Bis[2-(2,2'-bipyridine-6-yl)-1,3,4-oxadiazo-5-yl]-9,9-dimethylfluorene; 1,3-Bis[2-(4-tert-butylphenyl)-1,3,4-oxadiazo-5-yl]benzene; 2-(naphthalen-2-yl)-4,7-diphenyl-1,10-phenanthroline; 2,9-Bis(naphthalen-2-yl)-4,7-diphenyl-1,10-phenanthroline; Tris(2,4,6-trimethyl-3-(pyridin-3-yl)phenyl)borane; 1-methyl-2-(4-(naphthalen-2-yl)phenyl)-1H-imidazo[4,5-f][1,10]phenanthroline; Phenyl-dipyrenylphosphine oxide; Naphtahlintetracarbonsäuredianhydrid bzw. dessen Imide; Perylentetracarbonsäuredianhydrid bzw. dessen Imide; Materialien basierend auf Silolen mit einer Silacyclopentadieneinheit oder weitere Heterozyklen wie in der EP 2 092 041 B1 beschrieben.

Das erfindungsgemäße salzartige Derivat besteht aus einem oder mehreren Anionen und Kationen, wobei das Anion sich von der Phosphor- oder der Phosphonsäure herleiten lässt, in welcher eine oder zwei der Sauerstoffgruppen durch organische Reste modifiziert sind.

Das Metall-Kation M kann ausgewählt sein aus der Gruppe der Alkali-, Erdalkali-, Hauptgruppen-, Nebengruppen-, Lanthanoid- und Übergangsmetalle. Besonders bevorzugt sind die Metalle der oben genannten Gruppen, welche in salzartigen Verbindungen stabile, einfach positiv geladene Kationen bilden.

Des Weiteren besonders bevorzugt sind die Metalle der ersten Hauptgruppe des Periodensystems, die Alkali-Metalle. Die Gruppe der Alkali-Metalle enthält die Elemente Li, Na, K, Rb, und Cs. Aufgrund ihrer Löslichkeit im Matrixmaterial und der leichten Verdampfbarkeit der salzartigen Verbindungen können sich die Alkali-Metalle besonders zum Aufbau von n-Dotanden anbieten.

In einer besonderen Ausführungsform ist besonders bevorzugt, dass der Rest R über ein Sauerstoffatom an den Phosphor gebunden ist.

In einer weiteren besonderen Ausführungsform ist besonders bevorzugt, dass die Substituenten R1 und R2 jeweils einen organischen Rest tragen und über jeweils ein Sauerstoffatom an den Phosphor gebunden sind.

In einer besonderen Ausführungsform der Erfindung kann das organisch elektronische Bauelement ein salzartiges Derivat einer Phosphoroxo-Verbindung enthalten, welches aus der Gruppe der Phosphorsäureester und/oder Phosphonsäureester ausgewählt ist. Die Ester der Phosphoroxo-Verbindungen können dabei der allgemeinen Formel 2

Formel 2

oder der allgemeinen Formel 3

Formel 3

mit Z = O, S, Se entsprechen.

Die Ester der Phosphoroxoverbindungen in Form ihrer Phosphorsäureester (nach Formel 2) oder Phosphonsäureester (Formel 3) sind besonders bevorzugt, da zum einen die HOMO/LUMO-Verteilung des Kations besonders gut auf die im Stand der Technik genannten Elektronentransportmaterialien abgestimmt ist. Zum anderen können die sterischen Eigenschaften dieser Verbindungen zu einer besonders günstigen Herabsetzung der Sublimationstemperatur der salzartigen Verbindung beitragen. Man kann somit besonders potente Dotanden mit einer besonders tiefen Sublimationstemperatur erhalten.

In einer besonderen Ausführungsform der Erfindung kann das Kation des salzartigen Derivats der Phosphoroxo-Verbindung ausgewählt sein aus der Gruppe der schweren Alkalimetalle enthaltend Caesium und/oder Rubidium. Diese Auswahl kann besonders vorteilhaft sein, da die Löslichkeit der schweren Alkali-Metalle, im Vergleich zu denen der leichten Vertreter der Alkali-Metalle, in dem Matrixmaterial besser ist. Dies kann im Zusammenhang mit den erfindungsgemäßen Anionen zu einer besonders homogenen Verteilung innerhalb der Schicht führen. Desweiteren können die schweren Vertreter der Alkalimetalle zu Verbindungen führen, welche sich aufgrund der Größe des Metall-Kations besonders gut verdampfen lassen.

In einer besonderen Ausführungsform der Erfindung kann das organisch elektronische Bauelement ein salzartiges Derivat der Phosphoroxo-Verbindung mit einem Molekulargewicht größer oder gleich 70 g/mol und kleiner oder gleich 1000 g/mol und einer Sublimationstemperatur größer oder gleich 120°C und kleiner oder gleich 1200°C aufweisen. Ohne durch die Theorie gebunden zu sein ermöglicht dieser Molekularmassenbereich eine ausreichende Größe der Substituenten um die Symmetrie der salzartigen Verbindung derart zu stören, dass eine niedrigere Sublimationstemperatur erhalten wird. Die Coulomb-Wechselwirkung zwischen den Anionen und den Kationen kann derart verringert werden. Höhere Molekulargewichte können hingegen unvorteilhaft sein, da die Sublimationstemperatur der salzartigen Verbindung dann wieder als Funktion der Massenzunahme überproportional ansteigt. Im Rahmen der Verarbeitung hat sich zudem gezeigt, dass Verbindungen mit Sublimationstemperaturen zwischen größer oder gleich 120°C und kleiner oder gleich 1200°C sich aus der Gasphase besonders homogen abscheiden lassen. Dies bedeutet, dass man besonders homogene Schichten erhalten kann. Die Molekulargewichte der Verbindungen lassen sich leicht aus den Summenformeln errechnen und die Sublimationstemperaturen werden nach dem im Stand der Technik bekannten Verfahren bestimmt.

In einem weiteren Aspekt der Erfindung kann das organisch elektronische Bauelement salzartige Derivate von Phosphoroxo-Verbindung enthalten, welche ausgewählt sind aus der Gruppe der cyclischen Phosphorsäureester und/oder Phosphonsäureester. Die cyclischen Phosphor- oder Phosphonsäureester können besonders bevorzugt sein, da das relativ starre cyclische Gerüst sterisch derart raumgreifend ist, dass eine besonders hohe Absenkung der Sublimationstemperatur des Derivates erreicht werden kann.

In einer weiteren, erfindungsgemäßen Ausführungsform kann das organisch elektronische Bauelement ein salzartige Derivat der Phosphoroxo-Verbindungen in einer Schichtdicken-Konzentration von größer oder gleich 0,01 % und kleiner oder gleich 50 % in der elektronenleitenden Schicht vorliegen. Die Schichtdicken-Konzentration beschreibt dabei den volumenmäßigen Anteil des salzartigen Derivates an der gesamten, elektronenleitenden Schicht. Dieser Anteil lässt sich zum Beispiel anhand der Kationenverteilung innerhalb der Schicht, welche z.B. mittels einer energiedispersiven Röntgenstrukturanalyse (EDX) oder AAS (Atomabsorptionsspektroskopie) bestimmen wird, berechnen. In dem Falle, dass die Dotanden Charge-Transfer-Komplexe ausbilden, kann die Schichtdickenkonzentration mittels Messungen der UV-Absorption bestimmt werden.

Die Eigenschaften einer elektronenleitenden Schicht können durch den Zusatz eines salzartigen Dotanden verbessert werden. Der Dotand ist in der Lage ein Elektron an die Schicht abzugeben und kann somit zu einer Erhöhung der Leitfähigkeit der Schicht beitragen. Überraschenderweise hat sich gezeigt, dass Dotanden-Konzentrationen oberhalb und unterhalb des oben angegebenen Bereiches zu schlechteren Leitfähigkeiten führen können. Ohne durch die Theorie gebunden zu sein führen niedrigere Dotanden-Konzentrationen zu einer ungenügenden Elektroneninjektion in die leitende Schicht und höhere Dotanden-Konzentrationen zu einem Mangel an Elektronentransportkomponenten innerhalb der Schicht. In beiden Fällen ist die Leitfähigkeit der elektronenleitenden Schicht unzureichend.

In einem weiteren, erfindungsgemäßen Aspekt kann das Derivat eines Phosphoroxo-Salzes ein Caesium- oder Rubidium-Salz einer Verbindung sein, welche ausgewählt ist aus der Gruppe an Verbindungen umfassend 6,7,11,12,19,20,24,25-Octahydrodibenzo[G,R][1,3,6,9,12,14,17,20,2,13]-Octaoxadiphosphacyclodocosine-9-22-Diol 9,22-Dioxid;(4R)-22-Hydroxy-5,5-dimethyl-4-phenyl-1,3,2-dioxaphosphorinan 2-oxid;8,9-diphenyldiphenanthro[4,3-d:3,4-f][1,3,2]dioxaphosphepin-18-ol 18-oxid;2,6-bis(triphenylsilyl)dinaphtho[2,1-d:1,2-f][1,3,2]dioxaphosphepin-4-ol 4-oxid;1-Butyl-3-methylimidazolium dibutylphosphate und entsprechenden di(C1-C10) Alkylderivate; Diphenylhydrogenphosphat; Bis(4-nitrophenyl)hydrogenphosphat; 2-naphthyl 4-[(E)-phenyldiazenyl]phenylhydrogenphosphat; Dinaphtho[2,1-d:1,2-f][1,3,2]dioxaphosphepin-4ol 4-oxid; (R)-3,3'-Bis[3,5-bis(trifluoromethyl)phenyl]-1,1'-binaphthyl-2,2'-diyl hydrogenphosphat; (S)-3,3'-Bis(2,4,6-triisopropylphenyl)-1,1'-binaphthyl-2,2'-diyl hydrogenphosphat; 18-Hydroxy-8,9-diphenyl-diphenanthro[4,3-d:3',4'-f][1,3,2]dioxaphosphepin-18-oxid; (11bR)-4-Hydroxy-2,6-bis(triphenylsilyl)dinaphtho-[2,1-d:1',2'f]-1,3,2-dioxaphosphepin 4-oxid; (R)-(-)-3,3'-Bis(triphenylsilyl)-1,1'-binaphthyl-2,2'-diyl hydrogenphosphat; Lithium carbamoylphosphat; D-myo-Inositol 1-Monophosphat; 6-Benzoyl-2-napthylphosphat; 4-Nitrophenyl phosphate bis(cyclohexylammonium) Salz Naphthol AS phosphat; Naphthol AS-MX phosphat; 4-(tert-pentyl)phenyl phosphat; Geranylgeranyl pyrophosphat; Napthol AS phosphat; Methylphosphonat; Trichloromethylphosphonat; Heptan-1,7-diyldiphosphonat; (heptylsulfanyl)methylphosphonat; 1-hydroxybutylphosphonat; 2-Phenylethylphosphonat; Butylhydrogentrichloromethylphosphonat; 4-Methoxyphenylphosphonat; 3-Phenylpropylphosphonat; Dimethyl allylphosphonat; 1-aminopentan-1,1-diyldiphosphonat; 4-iodobenzylphosphonat; ((2-cyano-ethyl)-phosphonomethyl-amino)acetat; 4-Ethoxyphenylphosphonat; (+-)-2-Amino-4-phosphonobutanat; Glyphosate-3-13C[(phosphonomethyl)amino]acetat; Amino(phenyl)methylphosphonat; 3-(Carboxymethyl-Phosphonomethyl-Amino)-Propionat; D(-)-2-Amino-5-Phosphonopentanat; 2-amino-7-phosphonoheptanat; Tetramethyl 2-oxopropan-1,3-diyldphosphonat; 2-methoxybenzylphosphonat; Tetraethylmethylendiphosphonat; Diethyl Methoxymethylphosphonat Methyl 6-[hydroxy(isopropoxy)phosphoryl]hexanoat; ((2-Cyano-Ethyl)-(Hydroxy-Methoxy-Phosphorylmethyl)-Amino)acetat; Dipropylchloromethylphosphonat; Amino[4-(trifluoromethyl)phenyl]methylphosphonat; [(4-chlorobenzyl)amino]methylphosphonat.
Die aufgeführten Verbindungen gehören zu der Gruppe der Phosphor- und Phosphonsäuresalze und können durch Ihren sterischen Aufbau und Ihre Valenzeigenschaften zu vorteilhaften HOMO/LUMO-Kombinationen zwischen dem elektronenleitenden Schichtmaterial und dem Anion des Dotanden führen. Dies kann zu einer erhöhen Elektroneninjektion des Dotanden und dadurch bedingt zu höheren Leitfähigkeiten der elektronenleitenden Schicht beitragen.

Des Weiteren erfindungsgemäß können die Kationen aus der oben dargestellten Gruppe an Phosphoroxo-Verbindungen ausgewählt sein aus der Gruppe der Natrium, Kalium, Caesium oder Rubidium.

Weiterhin erfindungsgemäß ist ein Verfahren zur Herstellung eines organisch elektronischen Bauelementes, aufweisend die Verfahrensschritte

a) Bereitstellen eines Substratträgers mit einer ersten Elektrode,
b) Aufbringen mindestens einer elektronenleitenden Schicht enthaltend ein Derivat eines Phosphoroxo-Salzes und ein organisches Matrixmaterial auf die erste Elektrode und
c) Aufbringen einer zweiten Elektrode, welche mit der elektronenleitenden Schicht in elektrisch leitendem Kontakt steht,

wobei das Aufbringen der elektronenleitenden Schicht in Schritt b) durch einen Lösemittel- oder Verdampfungsprozess erfolgt.

In einer besonderen Ausführungsform kann das erfindungsgemäße Verfahren genutzt werden, um eine Zwischenschicht auf einer Kathode eines organisch elektrischen Bauelementes aufzubringen.

Besonders bevorzugt wird im Verfahrensschritt b) der elektronenleitende Bereich mittels Gasphasenabscheidung, besonders bevorzugt mittels physikalischer Gasphasenabscheidung (PVD) erzeugt. In diesem Schritt kann der Dotand bevorzugt zusammen mit der elektronenleitenden Schicht abgeschieden werden. Mittels dieses Verfahrens erhält man besonders homogene und gleichmäßige Schichten. Lösemittelprozesse in Schritt b) können bevorzugt so durchgeführt werden, dass die Komponenten der elektronenleitenden Schicht und der Dotand aus einem wasserfreien Lösemittel auf ein Substrat abgeschieden werden.

Gegenstand der Erfindung ist weiterhin ein Verfahren zur Herstellung eines organisch elektronischen Bauelementes, wobei die Phosphoroxo-Salze vor dem Aufbringen einen Wassergehalt von größer oder gleich 0 Gewichts-% und kleiner oder gleich 0,25 Gewichts-% aufweisen. Besonders bevorzugt kann das Phosphoroxo-Salz vor dem Aufbringen einen Wassergehalt von 0 Gewichts-% aufweisen. Ein Phosphoroxo-Salz mit einem Wassergehalt von 0 Gewichts-% schließt auch Phosphoroxo-Salze mit Spuren von Wasser unterhalb der Bestimmungsgrenze mit ein. Der Wassergehalt kann dabei nach den gängigen, dem Fachmann bekannten Methoden bestimmt werden. Genannt sei an dieser Stelle die Feuchtebestimmung nach Karl-Fischer.

In einer weiteren Ausgestaltung der Erfindung kann das Aufbringen der elektronenleitenden Schicht in dem Verfahren zur Herstellung eines organisch elektronischen Bauelementes in Schritt b) durch Spincoating, Slotcoating, Drucken oder Rakeln erfolgen. Diese Verfahren können besonders bevorzugt zu reproduzierbaren Herstellung homogener und hoch ortsaufgelöster Schichten verwendet werden. Gerade im Nassprozess können durch die verbesserte Löslichkeit der erfindungsgemäßen Verbindungen sehr homogene Schichten erhalten werden.

In einer weiteren, erfindungsgemäßen Ausgestaltung kann das organisch elektronische Bauelement innerhalb einer organischen Solarzelle, einem organischen Transistor, einem licht-emittierenden, organischen Bauteil, einer organischen Leuchtdiode und/oder einer organischen licht-emittierenden elektrochemischen Zelle angeordnet sein.

Der Aufbau organisch elektrischer Bauelemente wird nachfolgend anhand von Figuren näher erläutert. Die Figuren zeigen

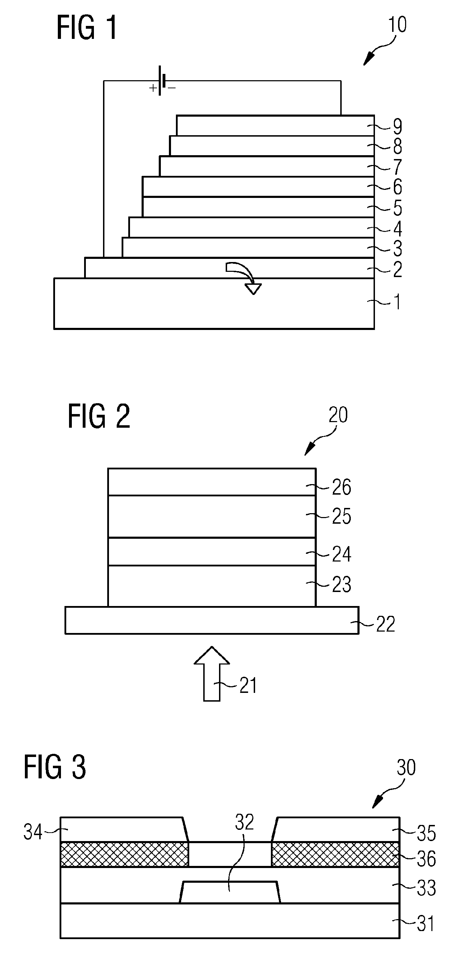

Fig. 1 schematisch den Aufbau einer organischen Leuchtdiode (10). Die Leuchtdiode ist aufgebaut aus einer Glas-Schicht (1); Indium-Zinn-Oxid (ITO)-Schicht (2); Loch-InjektorSchicht (3); Loch-Transportschicht (HTL) (4); Emitter-Schicht (EML) (5); Loch-Blocker-Schicht (HBL) (6); ElektronenTransportschicht (ETL) (7); Elektronen-Injektorschicht (8)und einer Kathoden-Schicht (9);

Fig. 2 schematisch den Aufbau einer organischen Solarzelle mit PIN-Struktur (20), welche Licht (21) in elektrischen Strom umwandelt. Die Solarzelle besteht aus einer Schicht aus Indium-Zinn-Oxid (22); einer p-dotierten Schicht(23); einer Absorptions-Schicht (24); einer n-dotierten Schicht (25) und einer Metall-Schicht (26);

Fig. 3 schematisch einen möglichen Querschnitt eines organischen Feld-Effekt-Transistors (30). Auf einem Substrat (31) ist eine Gate-Elektrode (32), ein Gate-Dielektrikum (33), ein Source and Drain-Kontakt (34 + 35) und ein organischer Halbleiter (36) aufgebracht. Die schraffierten Stellen zeigen die Stellen an denen eine Kontaktdotierung hilfreich ist.

Beispiele

I) Herstellung des Vergleichsmaterials

Auf einer ITO-(Indium-Tin-Oxide = Indium-dotiertes Zinnoxid) Elektrode wird durch thermisches Verdampfen eine 200 nm dicke Schicht des Elektronenleiters BCP (2,9-Dimethyl-4,7-diphenyl-1,10-phenanthroline) abgeschieden. Als Gegenelektrode wird eine 150 nm dicke Aluminiumschicht verwendet.

II. Herstellung organisch elektrisch leitfähiger Schichten mit einem Phosphorsäure-Derivat

In drei weiteren Experimenten wird Di-Caesium phenyl phosphat in Konzentrationen von 2 Gewichts-%, 5 Gewichts-% und 10 Gewichts-% relativ zur Verdampfungsrate von BCP (2,9-Dimethyl-4,7-diphenyl-1,10-phenanthroline) eindotiert.

Im Rahmen einer physikalischen Charakterisierung erhält man für die Strom-Spannungs-Charakteristika der dotierten, organischen Bauelemente, dass die Stromdichte der dotierten Schichten bei gleicher Spannung deutlich oberhalb der des Vergleichssubstrates liegen. Dieser Effekt ist zumindest im unteren Konzentrationsbereich annähernd proportional zur Dotierungsstärke. Die Erhöhung der Stromdichte lässt somit auf eine Erhöhung der Ladungsträgerdichte und/oder -beweglichkeit schließen.

III. Herstellung organisch elektrisch leitfähiger Schichten mit einem Phosphonsäure-Derivat

In drei weiteren Experimenten wird Di-Caesiumdecylphosphonate in Konzentrationen von 2 Gewichts-%, 5 Gewichts-% und 10 Gewichts-% relativ zur Verdampfungsrate von BCP (2,9-Dimethyl-4,7-diphenyl-1,10-phenanthroline) eindotiert.

Im Rahmen einer physikalischen Charakterisierung erhält man für die Strom-Spannungs-Charakteristika der dotierten, organischen Bauelemente, dass die Stromdichte der dotierten Schichten bei gleicher Spannung deutlich oberhalb der des Vergleichssubstrates liegen. Dieser Effekt ist annähernd proportional zur Dotierungsstärke. Die Erhöhung der Stromdichte lässt somit auf eine Erhöhung der Ladungsträgerdichte und/oder -beweglichkeit schließen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen

**Patentansprüche**

1.  Organisch elektronisches Bauelement enthaltend ein Substrat, eine erste Elektrode, eine zweite Elektrode und mindestens eine, zwischen der ersten und zweiten Elektrode angeordnete, elektronenleitende Schicht, **dadurch gekennzeichnet, dass** die elektronenleitende Schicht ein salzartiges Derivat einer Phosphoroxo-Verbindung gemäß allgemeiner Formel 1 als n-Dotand enthält

$$X \left[ \begin{matrix} O \\ \| \\ R_2 - P - O \\ | \\ R_1 \end{matrix} \right]^{n-} Y\ M^{m+}$$

$$\text{(Formel 1),}$$

wobei X, Y größer 0 und kleiner oder gleich 3; n, m ganzzahlig und n größer oder gleich 1 und kleiner oder gleich 2 und m größer oder gleich 1 und kleiner oder gleich 3; M = Metall und $R_1$ = O, S, Se, O-R, S-R, Se-R und $R_2$ = R, O-R, S-R, Se-R und R aus der Gruppe enthaltend substituierte oder unsubstituierte Alkyl, langkettiges Alkyl, Cycloalkyl, Halogenalkyl, Aryl, Arylene, Halogenaryl, Heteroaryl, Heteroarylene, Heterocycloalkylene, Heterocycloalkyl, Halogenheteroaryl, Alkenyl, Halogenalkenyl, Alkinyl, Halogenalkinyl, Ketoaryl, Halogenketoaryl, Ketoheteroaryl, Ketoalkyl, Halogen-Ketoalkyl, Ketoalkenyl, Halogenketoalkenyl ausgewählt ist.

2.  Organisch elektronisches Bauelement nach Anspruch 1, wobei das salzartige Derivat der Phosphoroxo-Verbindung ausgewählt ist aus der Gruppe der Phosphorsäureester und/oder Phosphonsäureester.

3.  Organisch elektronisches Bauelement nach einem der vorhergehenden Ansprüche, wobei das Kation des salzartigen Derivats der Phosphoroxo-Verbindungen ausgewählt ist aus der Gruppe der schweren Alkalimetalle enthaltend Caesium und/oder Rubidium.

4.  Organisch elektronisches Bauelement nach einem der vorhergehenden Ansprüche, wobei das salzartige Derivat der Phosphoroxo-Verbindung ein Molekulargewicht größer oder gleich 70 g/mol und kleiner oder gleich 1000 g/mol und eine Sublimationstemperatur größer oder gleich 120°C und kleiner oder gleich 1200°C aufweisen.

5.  Organisch elektronisches Bauelement nach einem der vorhergehenden Ansprüche, wobei das salzartige Derivat der Phosphoroxo-Verbindung ausgewählt ist aus der Gruppe der cyclischen Phosphorsäureester und/oder Phosphonsäureester.

6. Organisch elektronisches Bauelement nach einem der vorhergehenden Ansprüche, wobei das salzartige Derivat der Phosphoroxo-Verbindungen in einer Schichtdicken-Konzentration von größer oder gleich 0,01 % und kleiner oder gleich 50 % in der elektronenleitenden Schicht vorliegen.

7. Organisch elektronisches Bauelement nach einem der vorhergehenden Ansprüche, wobei das Derivat eines Phosphoroxo-Salzes ein Cäsium- oder Rubidium-Salz einer Verbindung ist, welche ausgewählt ist aus der Gruppe an Verbindungen umfassend 6,7,11,12,19,20,24,25-Octahydrodibenzo[G,R][1,3,6,9,12,14,17,20,2,13]-Octaoxadiphosphacyclodocosine-9-22-Diol 9,22-Dioxid;(4R)-22-Hydroxy-5,5-dimethyl-4-phenyl-1,3,2-dioxaphosphorinan 2-oxid;8,9-diphenyldiphenanthro[4,3-d:3,4-f][1,3,2]dioxaphosphepin-18-ol 18-oxid;2,6-bis(triphenylsilyl)dinaphtho[2,1-d:1,2-f][1,3,2]dioxaphosphepin-4-ol 4-oxid;1-Butyl-3-methylimidazolium dibutylphosphate und entsprechenden di(C1-C10) Alkylderivate; Diphenylhydrogenphosphat; Bis(4-nitrophenyl)hydrogenphosphat; 2-naphthyl 4-[(E)-phenyldiazenyl]phenylhydrogenphosphat; Dinaphtho[2,1-d:1,2-f][1,3,2]dioxaphosphepin-4ol 4-oxid; (R)-3,3'-Bis[3,5-bis(trifluoromethyl)phenyl]-1,1'-binaphthyl-2,2'-diyl hydrogenphosphat; (S)-3,3'-Bis(2,4,6-triisopropylphenyl)-1,1'-binaphthyl-2,2'-diyl hydrogenphosphat; 18-Hydroxy-8,9-diphenyl-diphenanthro[4,3-d:3',4'-f][1,3,2]dioxaphosphepin-18-oxid; (11bR)-4-Hydroxy-2,6-bis(triphenylsilyl)dinaphtho-[2,1-d:1',2'f]-1,3,2-dioxaphosphepin 4-oxid; (R)-(-)-3,3'-Bis(triphenylsilyl)-1,1'-binaphthyl-2,2'-diyl hydrogenphosphat; (Prüfen) Lithium carbamoylphosphat; D-myo-Inositol 1-Monophosphat; 6-Benzoyl-2-napthylphosphat; 4-Nitrophenyl phosphate bis(cyclohexylammonium) Salz Naphthol AS phosphat; Naphthol AS-MX phosphat; 4-(tert-pentyl)phenyl phosphat; Geranylgeranyl pyrophosphat; Napthol AS phosphat; Methylphosphonsat; Trichloromethylphosphonat; Heptan-1,7-diyldiphosphonat; (heptylsulfanyl)methylphosphonat; 1-hydroxybutylphosphonat; 2-Phenylethylphosphonat; Butylhydrogentrichloromethylphosphonat; 4-Methoxyphenylphosphonat; 3-Phenylpropylphosphonat; Dimethyl allylphosphonat; 1-aminopentan-1,1-diyldiphosphonat; 4-iodobenzylphosphonat; ((2-cyano-ethyl)-phosphonomethyl-amino)acetat; 4-Ethoxyphenylphosphonat; (+-)-2-Amino-4-phosphonobutanat; Glyphosate-3-13C[(phosphonomethyl)amino]acetat; Amino(phenyl)methylphosphonat; 3-(Carboxymethyl-Phosphonomethyl-Amino)-Propionat; D(-)-2-Amino-5-Phosphonopentanat; 2-amino-7-phosphonoheptanat; Tetramethyl 2-oxopropan-1,3-diyldphosphonat; 2-methoxybenzylphosphonat; Tetraethylmethylendiphosphonat; Diethyl Methoxymethylphosphonat Methyl 6-[hydroxy(isopropoxy)phosphoryl]hexanoat; ((2-Cyano-Ethyl)-(Hydroxy-Methoxy-Phosphorylmethyl)-Amino)acetat; Dipropylchloromethylphosphonat; Amino[4-(trifluoromethyl)phenyl]methylphosphonat; [(4-chlorobenzyl)amino]methylphosphonat.

8. Verfahren zur Herstellung eines organisch elektronischen Bauelementes nach einem der Ansprüche 1-7, aufweisend die Verfahrensschritte

    a) Bereitstellen eines Substratträgers mit einer ersten Elektrode,
    b)Aufbringen mindestens einer elektronenleitenden Schicht enthaltend ein Derivat eines Phosphoroxo-Salzes und ein organisches Matrixmaterial auf die erste Elektrode und
    c) Aufbringen einer zweiten Elektrode, welche mit der elektronenleitenden Schicht in elektrisch leitendem Kontakt steht,

wobei das Aufbringen der elektronenleitenden Schicht in Schritt b) durch einen Lösemittel- oder Verdampfungsprozess erfolgt.

9. Verfahren zur Herstellung eines organisch elektronischen Bauelementes nach Anspruch 8, wobei die Phosphoroxo-Salze vor dem Aufbringen einen Wassergehalt von größer oder gleich 0 Gewichts-% und kleiner oder gleich 0,25 Gewichts-% aufweisen.

10. Verfahren zur Herstellung eines organisch elektronischen Bauelementes nach einem der Ansprüche 8 oder 9, wobei das Aufbringen der elektronenleitenden Schicht in Schritt b) durch Spincoating, Slotcoating, Drucken oder Rakeln erfolgt.

11. Organisch elektronisches Bauelement nach einem der Ansprüche 1 - 7, wobei das organisch elektronische Bauelement innerhalb einer organischen Solarzelle, einem organischen Transistor, einem licht-emittierenden, organischen Bauteil, einer organischen Leuchtdiode und/oder einer organischen licht-emittierenden elektrochemischen Zelle angeordnet ist.

**Claims**

1. Organic electronic component comprising a substrate, a first electrode, a second electrode and at least one electron-conducting layer disposed between the first and second electrodes, **characterized in that** the electron-conducting layer comprises a salt-type derivative of a phosphorus oxo compound of the general formula 1 as n-dopant

$$X \left[ \begin{array}{c} R_2 - \underset{\underset{R_1}{|}}{\overset{\overset{O}{||}}{P}} - O \end{array} \right]^{n-} Y\ M^{m+} \qquad \text{(formula 1)}$$

where X, Y are greater than 0 and less than or equal to 3; n, m are integers and n is greater than or equal to 1 and less than or equal to 2 and m is greater than or equal to 1 and less than or equal to 3; M = metal and $R_1$ = 0, S, Se, O-R, S-R, Se-R and $R_2$ = R, O-R, S-R, Se-R, and R is selected from the group comprising substituted and unsubstituted alkyl, long-chain alkyl, cycloalkyl, haloalkyl, aryl, arylene, haloaryl, heteroaryl, heteroarylene, heterocycloalkylene, heterocycloalkyl, haloheteroaryl, alkenyl, haloalkenyl, alkynyl, haloalkynyl, ketoaryl, haloketoaryl, ketoheteroaryl, ketoalkyl, haloketoalkyl, ketoalkenyl, haloketoalkenyl.

2. Organic electronic component according to Claim 1, wherein the salt-type derivative of the phosphorus oxo compound is selected from the group of the phosphoric esters and/or phosphonic esters.

3. Organic electronic component according to either of the preceding claims, wherein the cation of the salt-type derivative of the phosphorus oxo compounds is selected from the group of the heavy alkali metals comprising cesium and/or rubidium.

4. Organic electronic component according to any of the preceding claims, wherein the salt-type derivative of the phosphorus oxo compound has a molecular weight greater than or equal to 70 g/mol and less than or equal to 1000 g/mol, and a sublimation temperature greater than or equal to 120°C and less than or equal to 1200°C.

5. Organic electronic component according to any of the preceding claims, wherein the salt-type derivative of the phosphorus oxo compound is selected from the group of the cyclic phosphoric esters and/or phosphonic esters.

6. Organic electronic component according to any of the preceding claims, wherein the salt-type derivative of the phosphorus oxo compounds is present in the electron-conducting layer in a layer thickness concentration of greater than or equal to 0.01% and less than or equal to 50%.

7. Organic electronic component according to any of the preceding claims, wherein the derivative of a phosphorus oxo salt is a cesium or rubidium salt of a compound selected from the group of compounds comprising 6,7,11,12,19,20,24,25-octahydrodibenzo[g,r]-[1,3,6,9,12,14,17,20,2,13]-octaoxadiphosphacyclodocosine-9,22-diol 9,22-dioxide; (4R)-22-hydroxy-5,5-dimethyl-4-phenyl-1,3,2-dioxaphosphorinan 2-oxide; 8,9-diphenyldiphenanthro[4,3-d:3,4-f][1,3,2]dioxaphosphepin-18-ol 18-oxide; 2,6-bis(triphenylsilyl)dinaphtho[2,1-d:1,2-f][1,3,2]dioxaphosphepin-4-ol 4-oxide; 1-butyl-3-methylimidazolium dibutylphosphate and corresponding di(C1-C10)alkyl derivatives; diphenyl hydrogenphosphate; bis(4-nitrophenyl) hydrogenphosphate; 2-naphthyl 4-[(E)-phenyldiazenyl]phenylhydrogenphosphate; dinaphtho[2,1-d:1,2-f][1,3,2]dioxaphosphepin-4-ol 4-oxide; (R)-3,3'-bis[3,5-bis(trifluoromethyl)phenyl]-1,1'-binaphthyl-2,2'-diyl hydrogenphosphate; (S)-3,3'-bis(2,4,6-triisopropyl-phenyl)-1,1'-binaphthyl-2,2'-diyl hydrogenphosphate; 18-hydroxy-8,9-diphenyldiphenanthro[4,3-d:3',4'-f][1,3,2]-dioxaphosphepin 18-oxide; (llbR)-4-hydroxy-2,6-bis(triphenylsilyl)dinaphtho-[2,1-d:1',2'f]-1,3,2-dioxaphosphepin 4-oxide; (R)-(-)-3,3'-bis(triphenylsilyl)-1,1'-binaphthyl-2,2'-diyl hydrogenphosphate; (check) lithium carbamoylphosphate; D-myo-inositol 1-monophosphate; 6-benzoyl-2-naphthyl phosphate; 4-nitrophenyl phosphate bis(cyclohexylammonium) salt; Naphthol AS phosphate; Naphthol AS-MX phosphate; 4-(tert-pentyl)phenyl phosphate; geranylgeranyl pyrophosphate; Naphthol AS phosphate; methyl phosphonate; trichloromethyl phosphonate; heptane-1,7-diyl diphosphonate; (heptylsulfanyl)methyl phosphonate; 1-hydroxybutyl phosphonate; 2-phenylethyl phosphonate; butylhydrogentrichloromethyl phosphonate; 4-methoxyphenyl phosphonate; 3-phenylpropyl phosphonate; dimethylallyl phosphonate;

1-aminopentane-1,1-diyl diphosphonate; 4-iodobenzyl phosphonate; ((2-cyanoethyl)-phosphonomethylamino)acetate; 4-ethoxyphenyl phosphonate; (+-)-2-amino-4-phosphonobutanate; glyphosate 3-13C[(phosphonomethyl)amino]acetate; amino(phenyl)methyl phosphonate; 3-(carboxymethylphosphonomethylamino)-propionate; D-(-)-2-amino-5-phosphonopentanate; 2-amino-7-phosphonoheptanate; tetramethyl 2-oxopropane-1,3-diyl diphosphonate; 2-methoxybenzyl phosphonate; tetraethylmethylene diphosphonate; diethyl methoxymethyl-phosphonate; methyl 6-[hydroxy(isopropoxy)phosphoryl]-hexanoate; ((2-cyanoethyl)(hydroxymethoxyphosphoryl-methyl)amino)acetate; dipropylchloromethylphosphonate; amino[4-(trifluoromethyl)phenyl]methylphosphonate; [(4-chlorobenzyl)amino]methylphosphonate.

8. Process for producing an organic electronic component according to any of Claims 1-7, having the process steps of

   a) providing a substrate carrier with a first electrode,
   b) applying at least one electron-conducting layer comprising a derivative of a phosphorus oxo salt and an organic matrix material to the first electrode and
   c) applying a second electrode in electrically conductive contact with the electron-conducting layer,

   wherein the application of the electron-conducting layer in step b) is effected by a solvent or evaporation process.

9. Process for producing an organic electronic component according to Claim 8, wherein the phosphorus oxo salts, prior to application, have a water content of greater than or equal to 0% by weight and less than or equal to 0.25% by weight.

10. Process for producing an organic electronic component according to either of Claims 8 and 9, wherein the electron-conducting layer is applied in step b) by spincoating, slot-coating, printing or knife-coating.

11. Organic electronic component according to any of Claims 1-7, wherein the organic electronic component is disposed within an organic solar cell, an organic transistor, a light-emitting organic component, an organic light-emitting diode and/or an organic light-emitting electrochemical cell.

**Revendications**

1. Composant électronique organique contenant un substrat, une première électrode, une deuxième électrode et au moins une couche disposée entre la première et la deuxième électrode et conductrice par électrons, **caractérisé en ce que** la couche conductrice par électrons contient, comme dopant de type n, un dérivé de type sel d'un composé phosphoroxo de formule générale 1

$$\left[ \begin{array}{c} O \\ \| \\ R_2\!-\!P\!-\!O \\ | \\ R_1 \end{array} \right]_X^{n-} \quad Y\ M^{m+} \quad \text{(formule 1),}$$

dans laquelle X, Y sont supérieurs à 0 et inférieurs ou égaux à 3 ; n, m sont des nombres entiers et n est supérieur ou égal à 1 et inférieur ou égal à 2 et m est supérieur ou égal à 1 et inférieur ou égal à 3 ; ; M = métal et $R_1$ = O, S, Se, O-R, S-R, Se-R et $R_2$ = R, O-R, S-R, Se-R et R est choisi dans le groupe comportant alcoyle substitué ou non substitué, alcoyle à longue chaîne, cycloalcoyle, haloalcoyle, aryle, arylène, haloaryle, hétéroaryle, hétéroarylène, hétérocycloalcoylène, hétérocycloal coyle, halohétéroaryle, alcényle, haloalcényle, alcynyle, haloalcinyle, cétoaryle, halocétoaryle, cétohétéroaryle, cétoal coyle, halo-cétoalcoyle, cétoalcényle, halocétoalcényle.

2. Composant électronique organique suivant la revendication 1, dans lequel le dérivé de type sel du composé phosphoroxo est choisi dans le groupe des esters de l'acyde phosphorique et/ou des esters de l'acide phosphonique.

3. Composant électronique organique suivant l'une des revendications précédentes, dans lequel le cation du dérivé de type sel des composés phosphoroxo est choisi dans le groupe des métaux alcalins lourds comprenant le césium et/ou le rubidium.

4. Composant électronique organique suivant l'une des revendications précédentes, dans lequel le dérivé de type sel du composé phosphoroxo a un poids moléculaire supérieur ou égal à 70 g/mole et inférieur ou égal à 1000 g/mole et un point de sublimation supérieur ou égal à 120°C et inférieur ou égal à 1200°C.

5. Composant électronique organique suivant l'une des revendications précédentes, dans lequel le dérivé de type sel du composé phosporoxo est choisi dans le groupe des esters de l'acide phosphorique et/ou des esters de l'acide phosphonique cycliques.

6. Composant électronique organique suivant l'une des revendications précédentes, dans lequel le dérivé du type sel des composés phosphoroxo est présent en une concentration d'épaisseur de couche supérieure ou égale à 0,01 % et inférieure ou égale à 50 % de la couche conductrice par des électrons.

7. Composant électronique organique suivant l'une des revendications précédentes, dans lequel le dérivé d'un sel phosphoroxo est un sel de césium ou de rubidium d'un composé choisi dans le groupe de composés comprenant le 9, 22-dioxyde de 6, 7, 11, 12, 19, 20, 24, 25-octahydrodibenzo [G,R] [1,3,6,9,12,14,17,20,2,13]-octaoxadiphosphacyclodocosine-9-22-diol ; le 2-oxyde de (4R)-22-hydroxy-5,5-diméthyl-4-phényl-1,3,2-dioxaphosphorinane ; le 8-oxyde de 8,9 - diphényldiphénanthro[4,3-d :3,4-f][1,3,2]dioxaphosphépin-4-ol ; le 4-oxyde de 2,6-bis(triphénylsilyl)dinaphto[2,1-d :1,2-f] [1,3,2]dioxaphosphépin-4-ol ; le dibutylphosphate de 1-butyl-3-méthylimidazolium et les dérivés dialcoyliques en C1 à C10 correspondants ; le phosphate acide de diphényle ; le phosphate acide de bis 4-nitrophényle ; le phosphate acide de 2-naphtyl 4[(E)-phényldiazényl] phényle ; le 4-oxyde de dinaphto [2,1-d :1',2'f][1,3,2]dioxaphosphépine-4ol; le phosphate acide de (R)-(-)-3,3'- bis[3,5-bis(trifluorométhyl)phényl]-1, 1'-binaphtyl-2,2'-diyle ; le phosphate acide de (S)-3,3'-bis(2,4,6-triisopropylphényl)-1,1'-binaphtyl-2,2'-diyle ; le 18-oxyde de 18-hydroxy-8,9-diphényl-diphénanthro[4,3-d :3',4'-f][1,3,2]dioxaphosphépine ; le 4-oxyde de (11bR)-4-hydroxy-2,6-bis(triphénylsilyl)dinaphto-[2,1-d :1',2'f]-1,3,2-dioxphosphépine ; le phosphate acide de (R)-(-)-3,3'-bis(triphénylsilyl)-1,1'-binaphtyl-2,2'-diyle ; le carbamoylphosphate de lithium (contrôlé) ; le 1-monophosphate de D-myo-inositol ; le 2-napthylphosphate de 6-benzoyle ; le phosphate de nitrophényle, le phosphate de naphtol AS sel de bis(cyclohexylammonium); le phosphate de naphtol AS-MX ; le phosphate de 4-(tert-pentyl)phényle ; le pyrophosphate de géranylgéranyle ; le phosphate de naphtol AS ; le phosphonate de méthyle ; le phosphonate de trichlorométhyle ; le diphosphonate d'heptane-1,7-diyle ; le phosphonate d'(heptylesulfanyl) méthyle ; le phosphonate de 1-hydroxybutyle ; le phosphonate de 2-phényléthyle ; le trichlorométhylphosphonate acide de butyle ; le phosphonate de 4-méthoxyphényle ; le phosphonate de 3-phénylepropyle ; l'allylphosphonate de diméthyle ; le 1,1 diyldiphosphonate de 1-aminopentane ; le phosphonate de 4-iododobenzyle, l'acétate de 2-cyanoéthyl)-phosphonométhyl-amino) ; le phosphonate de 4-éthoxyphényle ; le (+-)-2-amino-4-phosphono butanate ; l'acétate de glyphosate-3-13C [(phosphonométhyl)-amino] ; le phosphonate d'aminophénylméthyle ; le propionate de 3-(carboxyméthyl-phosphonométhyl-amino) ; le pentanate de D(-) 2-amino-5 phosphono ; l'heptanate de 2-amino-7-phosphono ; le 1,3-diyl-diphosphonate de tétraméthyl 2-oxopropane ; le phosphonate de 2-méthoxybenzyle ; le diphosphonate de tétraéthylméthylène ; le méthoxyméthylephosphonate de diéthyle ; le méthylhexanoate de 6-[hydroxy (isopropoxy)phosphoryle ; l'acétate de ((2-cyanoéthyl) (hydroxy-méthoxy-phosphorylméthyle)- amino ); le chlorométhylphosphonate de dipropyle ; le phosphonate d'amino [4-trifluorométhyl)-phényl]-méthyle ; le phosphonate de [4-(chlorobenzyl) amino] méthyle.

8. Procédé de fabrication d'un composant électronique organique suivant l'une des revendications 1 à 7, comportant les stades de procédé

   a) préparation d'un support de substrat ayant une première électrode,
   b) dépôt d'au moins une couche conductrice par électrons contenant un dérivé d'un sel de phosphoroxo et une matière de matrice organique sur la première électrode et
   c) dépôt d'une deuxième électrode, qui vient en contact conducteur de l'électricité avec la couche conductrice par des électrons,

le dépôt de la couche conductrice par des électrons au stade b) s'effectuant par une opération par solvant ou par évaporation.

9. Procédé de production d'un composant électronique organique suivant la revendication 8, dans lequel les sels de phosphoroxo ont, avant le dépôt, une teneur en eau supérieure ou égale à 0 % en poids et inférieure ou égale à 0,25 % en poids.

**10.** Procédé de production d'un composant électronique organique suivant l'une des revendications 8 ou 9, dans lequel on effectue le dépôt de la couche conductrice par des électrons au stade b) par spincoating, slotcoating, impression à la racle.

**11.** composant électronique organique suivant l'une des revendications 1 à 7, dans lequel le composant électronique organique est disposé au sein d'une pile solaire organique, d'un transistor organique, d'un composant organique électroluminescent, d'une diode électroluminescente organique et/ou d'une cellule électrochimique électrolumines-cente organique.

# FIG 1

# FIG 2

# FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2011039323 A2

- EP 2092041 B1

**In der Beschreibung aufgeführte Nicht-Patentliteratur**

- **HUANG, JINSONG et al.** *Adv. Funct. Mater.,* 2007, vol. 00, 1-8
- **WU, CHIH-I et al.** *APPLIED PHYSICS LETTERS,* 2006, vol. 88, 152104
- **XIONG, TAO et al.** *APPLIED PHYSICS LETTERS,* 2008, vol. 92, 263305

- **MENG-HUAN HO et al.** *Applied Physics Letters,* 2008, vol. 93, 083505
- **VON SCHMID et al.** *Organic Electronic Conference,* 24. September 2007
- **MENG-HUAN HOA et al.** *Applied Physics Letters,* 2007, vol. 91, 233507